# EUROPÄISCHE PATENTSCHRIFT

(11) **EP 1 055 256 B1**
(45) Veröffentlichungstag und Bekanntmachung des Hinweises auf die Patenterteilung: **09.11.2005**
(21) Anmeldenummer: 99901559.7
(22) Anmeldetag: 05.02.1999
(51) Int. Cl.: H01L 25/075, F21V 19/00

(54) **ZERSCHNEIDBARES LED-LEUCHTPANEEL**
LED LIGHT PANEL SEVERABLE BY CUTTING INTO A PLURALITY OF OPERABLE PIECES
PANNEAU DECOUPABLE A DIODES ELECTROLUMINESCENTES

(30) Priorität: 12.02.1998 CH 34998
(43) Veröffentlichungstag der Anmeldung: 29.11.2000
(73) Patentinhaber: STAUFERT, Gerhard, CH-4800 Zofingen (CH)
(72) Erfinder: STAUFERT, Gerhard, CH-4800 Zofingen (CH)
(74) Vertreter: Walser, Peter
(86) Internationale Anmeldenummer: PCT/CH1999/000051
(87) Internationale Veröffentlichungsnummer: WO 1999/041785

(56) Entgegenhaltungen:
- EP-A- 0 253 244
- DE-A- 19 621 148
- DE-U- 9 314 709
- FR-A- 2 601 519

## Beschreibung

Die Erfindung betrifft ein vielartig anwendbares, konfektionierbares Leuchtpaneel mit ungehäusten lichtemittierenden Dioden (LED-Chips).

Bekannt sind verschiedene lineare Anordnungen von gehäusten LED (EP0760577A2, US4573766, DE4237107, US5639158), die, an eine lichtleitende Struktur angeschlossen, zu linearen oder flächigen Beleuchtungseinheiten für LCD-Displays oder für Kopiergeräte führen.

Bekannt sind auch flächige Anordnung von gehäusten LED, beispielsweise zur Erzeugung von EXIT-Markierungen (US5655830), zur Erzeugung eines Automobilbremslichtes (EP0362993, US 5001609), von Verkehrsampeln (US5663719) und weitere ähnliche Anordnungen zur Erzeugung von Automobil-Rücklichtern bzw. -Blinklichtern.

Alle diese linearen und flächigen Anordnungen weisen die Nachteile auf, dass sie erstens gehäuste LED verwenden und dadurch in der Dichte der LED (maximal 4 LED/ cm²) und daraus resultierend in der totalen Leuchtdichte stark begrenzt sind, zweitens die Trägerelemente in Form und Grösse nach der Herstellung nicht beliebig veränderbar sind und drittens die gesamte Anordnung von vornherein auf eine spezifische Anwendung zugeschnitten ist.

Eine andere bekannte Anordnung (EP 760448A2) beschreibt einen integralen Lichtstreifen, bei dem vermutlich auf Keramikträgern vorgehäuste LED-Chips zum Einsatz kommen. Die beschriebene Anordnung und das entsprechende beschriebene Verfahren ist im Sinne der vorliegenden Erfindung dadurch eingeschränkt, dass sie einzig für die kostengünstige Herstellung sehr langer Lichtstreifen kleiner Leuchtdichte geeignet ist , deren Einsatzgebiet im wesentlichen auf Markierungsstreifen (Landebahnen usw.) beschränkt ist.

Bekannt sind weiter zahlreiche Verfahren zur direkten dünnfilmmässigen Herstellung von LED-Arrays (z.B. US5501990 und US5621225). Alle diese Verfahren dienen in der Regel zur Erzeugung von Displays und weisen im Sinne der vorliegenden Erfindung den Nachteil auf, dass sie nur als ganze nicht zertrennbare Einheiten betreibbar sind.

In einer weiteren bekannten Anordnung (US5598068) wird eine Beleuchtungseinheit mit zahlreichen LED für ein elektronisches Instrument beschrieben, bei der zur Erzielung einer hohen Betriebssicherheit die LED gruppenweise elektrisch seriell geschaltet sind, wobei die räumliche Verteilung aller LED so gewählt ist, dass sich die einzelnen seriell geschalteten Gruppen räumlich durchmischen. Auch diese Anordnung hat im Sinne der vorliegenden Erfindung den Nachteil, dass sie nur für eine spezifische Anwendung und nur als ganze nicht zertrennbare Einheit betrieben werden kann.

In einer anderen bekannten Anordnung (EP0253244A1) wird von Neiman, Courbevoie (FR) (Erfinder Boucheron, Jean Louis) ein Verfahren zur Herstellung von Leuchtplatten mittels gehäuster LED und eine durch dieses Verfahren erhaltene Signalleuchte beschrieben. Dieses Verfahren beruht ebenfalls auf der Verwendung von gehäusten LED und weist so den oben beschriebenen Nachteil einer geringen Dichte der LED und damit eine stark begrenzte totale Leuchtdichte auf. Es beschreibt weiter die Möglichkeit der Herstellung auf grossflächigen Trägerplatten, welche nachträglich in sogenannte Grundplatten zerschnitten werden. Diese Grundplatten besitzen eine durch die Herstellung der gesamten Trägerplatte fest vorgegebene Form und Grösse und können nur exakt in dieser Form und Grösse betrieben werden. Darüber hinaus ist die Lage der elektrischen Anschlüsse fest vorgegeben. Dies bringt in Summe den Nachteil mit sich, dass die Grundplatten jeweils nur für eine, von vornherein klar definierte Anwendung geeignet sind.

In einem japanisch abgefassten Patent (JP 9045965 A) beschreibt die Firma Nichia Chemical Industries, Ltd. eine keramische Gehäusung von LED-Chips und die Herstellung derselben.

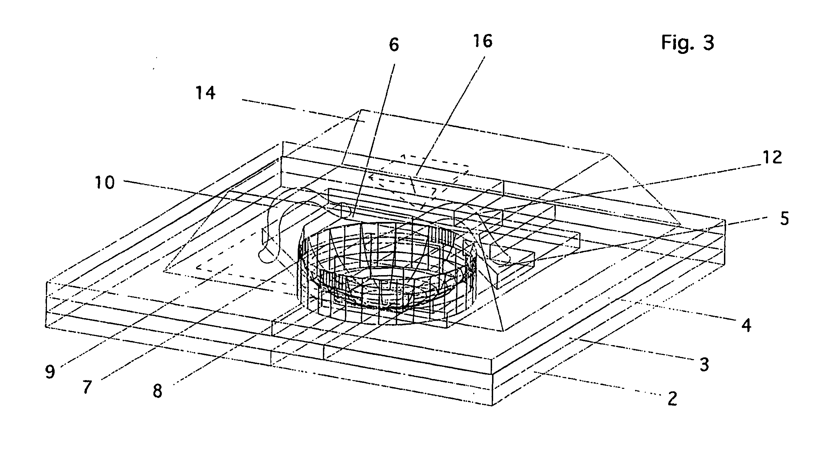

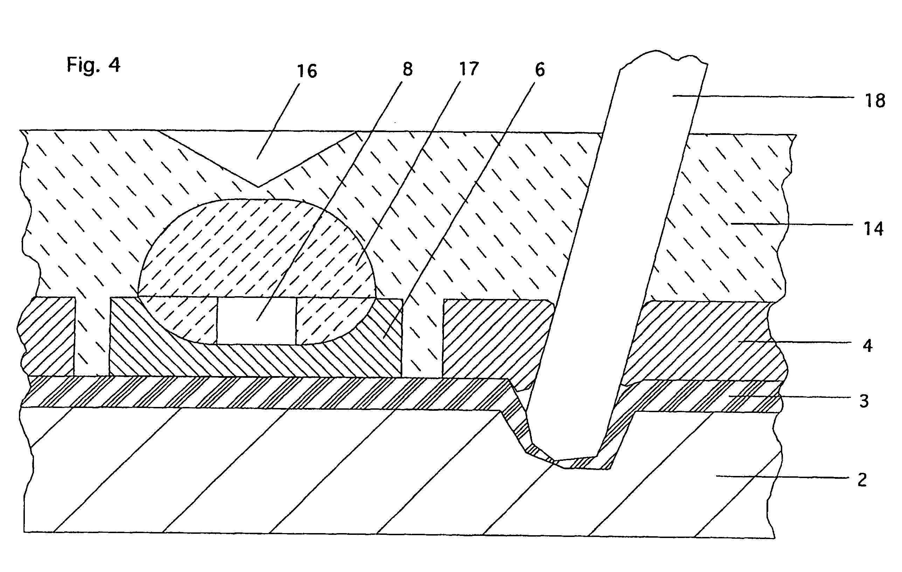

Den Figuren ist zu entnehmen, dass dabei die Gehäusung eines einzelnen LED-Chips oder die Vereinigung dreier in den Farben rot, grün und blau leuchtender LED-Chips in einem Gehäuse im Vordergrund steht. Prinzipiell könnte das den Figuren 3 und 4 zu entnehmende Verfahren aber auch zur Herstellung eines LED-Leuchtpaneels dienen, wobei dann aber, wegen der gezeigten einlagigen Zuführung zweier geometrisch parallel liegender elektrischer Leiter pro LED-Chip, alle auf einem solchen denkbaren Paneel angeordneten LED-Chips reihenweise elektrisch parallel mit der für die LED-Chips zulässigen elektrischer Spannung (z.B. 4 V) versorgt werden müssten. Im Sinne der vorliegenden Erfindung hat die denkbare Herstellung eines LED-Leuchtpanneels auf diese Weise die Nachteile einer stark reduzierten Flexibilität im Sinne der Formgebung und elektrischen Kontaktierbarkeit allenfalls abgetrennter Teilstücke, einer starken Einschränkung der Anzahl gleichzeitig betreibbarer LED-Chips und einer Unmöglichkeit der Bestückung des Paneels mit räumlich durchmischten LED-Chips unterschiedlichen Spannungsbedarfs.

Weiter bekannt ist, dass die Firma Nichia Chemical Industries, Ltd. , Tokushima , Japan schlanke Leuchtplatten hoher Leuchtdichte mit den fest vorgegebenen Formaten A5 bzw. A4 via Internet anbietet (http://www1a.meshnet.or.jp/nichia/led-e.htm). Diese Platten weisen jedoch den Nachteil fester, nicht veränderbarer Formate auf, was die Einsatzmöglichkeiten stark einschränkt.

Die Aufgabe der vorliegenden Erfindung besteht gegenüber den geschilderten Anordnungen darin, ein LED-Leuchtpaneel mit hoher Leuchtdichte und mit hoher Betriebssicherheit zu schaffen, das, anwendungsunabhängig oder anwendungsspezifisch, in grossen Flächen preiswert hergestellt werden kann und nach Zuführung einer in Industrie, Fahrzeugbau und Wohnbereich üblichen elektrischen Niederspannung an beliebigen Stellen der entsprechenden elektrischen Leiter des LED-Leuchtpaneels auch direkt als grossflächige Beleuchtungseinheit betrieben werden kann. Vorzugsweise soll dieses grossflächig hergestellte LED-Leuchtpaneel durch den Kunden oder durch den Hersteller anwendungsspezifisch in beliebig geformte, unterschiedliche Teilstücke zertrennbar sein, die, jedes für sich alleine nach Zuführung einer in Industrie, Fahrzeugbau und Wohnbereich üblichen elektrischen Niederspannung direkt als leuchtende Einheiten betreibbar sind.

Diese Aufgabe wird erfindungsgemäss durch die kennzeichnenden Merkmale des Patentanspruches 1 gelöst. Vorteilhafte Weiterbildungen der Erfindung ergeben sich nach den Merkmalen der abhängigen Patentansprüche.

Das erfindungsgemässe LED-Leuchtpaneel weist einen Aufbau von elektrisch leitenden Strukturen auf, der über die gesamte Fläche die gewünschte elektrische Spannung abgreifbar macht. Auf diesem Aufbau ist eine Vielzahl von - ungehäusten - LED-Chips montierbar und elektrisch so kontaktierbar, dass sie entweder alle parallel oder vorzugsweise, je in Gruppen definierter Grösse, in Serie schaltbar sind, wobei eine solche in Serie geschaltete Gruppe jeweils eine kleinste funktionsfähige Untereinheit bildet und alle diese kleinsten funktionsfähigen Untereinheiten parallel mit elektrischer Spannung versorgbar sind. Zur Erhöhung der gewünschten Anwendungsflexibilität ist der Aufbau der elektrisch leitenden Strukturen so gewählt, dass die LED-Chips ohne Mehraufwand von einer möglichst grossen (z.B. 25 LED/cm² oder mehr) bis zu einer lockeren räumlichen Dichte (z.B. 1 LED/cm² oder weniger) montierbar und kontaktierbar sind. Zur Verbesserung der Lichtausbeute kann die Basis-Elektrode für jeden der LED-Chips hohlspiegelartig geformt sein. Der gesamte Aufbau kann von einer formfesten optisch transparenten Schicht überzogen sein, die nachträglich (warm) so formbar ist, dass, wahlweise in Kombination mit der genannten hohlspiegelartigen Form der Basis-Elektrode, eine gewünschte räumliche Verteilung der Lichtabstrahlung entsteht und die darüber hinaus einen chemischen und mechanischen Schutz der gesamten Anordnung gewährleistet.

Ein erfindungsgemässes Ausführungsbeispiel wie auch weitere Vorteile der Erfindung sind nachfolgend anhand der Zeichnungen 1 - 5 näher erläutert. Es zeigen:
- Fig. 1: die perspektivische Gesamtansicht eines Ausschnittes des LED-Leuchtpaneels
- Fig. 2: die perspektivische Ansicht einer kleinsten funktionsfähigen Untereinheit
- Fig. 3: die perspektivische Ansicht der Umgebung eines einzelnen LED-Chips
- Fig. 4: den Querschnitt durch ein kleines Stück des LED-Leuchtpaneels
- Fig. 5: Den Grundriss eines Ausschnittes des LED-Leuchtpaneels

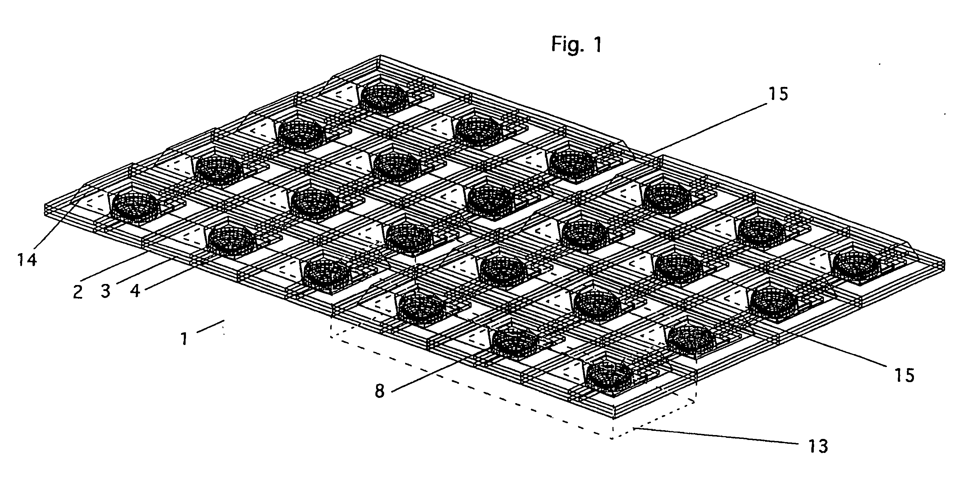

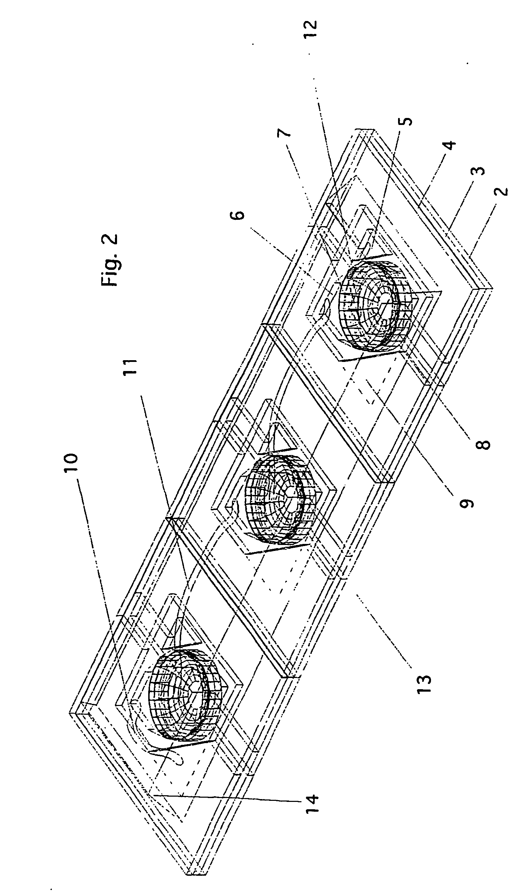

Das bis zu Quadratmetern grosse, streifenförmige bis quadratische LED-Leuchtpaneel 1 nach Fig. 1 beinhaltet, wie in Fig. 2 und Fig. 3 deutlich sichtbar, eine durchgehende untere elektrisch leitende Schicht 2 , eine Isolationsschicht 3 und eine netzartig strukturierte, obere elektrisch leitende Schicht 4. Die Isolationsschicht 3 weist in regelmässigen Abständen Öffnungen 5 auf, so dass die untere elektrisch leitende Schicht 2 dort von oben kontaktiertbar ist. Auf diese Weise ist ein Aufbau von elektrisch leitenden Strukturen vorhanden, bei dem die gewünschte elektrische Spannung über die gesamte Fläche abgreifbar ist.

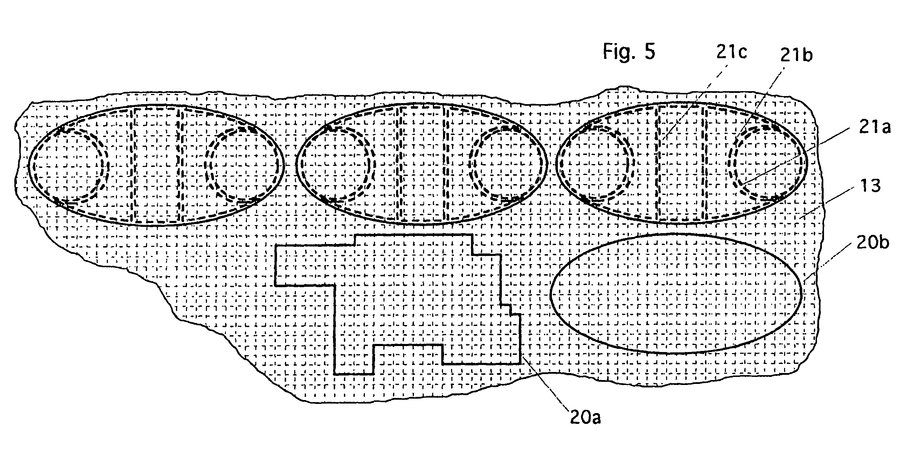

Die LED-Chips 8 sind in den quadratischen Zwischenräumen der netzartig strukturierten oberen elektrisch leitenden Schicht 4 angeordnet, wobei die Isolationsschicht 3 und die darunterliegende untere elektrisch leitende Schicht 2 als Träger verwendet wird. An den für die Montage der LED-Chips 8 vorgesehenen Orten, sind die beiden Trägerschichten 2, 3 beispielsweise mittels eines Prägevorganges, hohlspiegelartig geformt und tragen eine lokal begrenzte, elektrisch leitende und optisch gut reflektierende Schicht (z.B. Silber), so dass dort ein elektrisch leitender Hohlspiegel 7 mit ebenen Anschlussflächen 6 entsteht. Die LED-Chips 8 sind an den gewünschten Stellen beispielsweise mittels Leitkleber auf diesem elektrisch leitenden Hohlspiegel 7 befestigt und basisseitig elektrisch kontaktiert. Durch einen elektrischen Leiter 10 , der z.B. mittels Drahtbonden von der oberen elektrisch leitenden Schicht 4 zu einer ersten Anschlussfläche 6 eines Hohlspiegels 7 angebracht ist, durch weitere elektrische Leiter 11, die jeweils von der Top-Elektrode der LED-Chips 8 zur nächsten Anschlussfläche 6 eines Hohlspiegels 7 führen und einen letzten elektrischen Leiter 12 der von der Top-Elektrode der letzten LED-Chips 8 einer Serie zu der unteren elektrisch leitenden Schicht 2 führt, ist eine in Abhängigkeit von der gewünschten Versorgungsspannung definierbare Anzahl von LED-Chips in Serie schaltbar. Durch diese Anordnung werden die seriell geschalteten Untergruppen von LED-Chips 8 parallel mit elektrischer Spannung versorgt. Dies führt erfindungsgemäss dazu, dass sowohl ein grosses LED-Leuchtpaneel 1 als auch ein in Fig. 5 ersichtliches abtrennbares Teilstück 20 welches die Fläche einer, von einer Gruppe seriell geschalteter LED-Chips 8 gebildeten, kleinsten funktionsfähigen Untereinheit 13 nicht unterschreitet, zu leuchten beginnt, wenn die untere elektrisch leitende Schicht 2 und die obere elektrisch leitende Schicht 4 mit der vorgesehenen elektrischen Spannungsdifferenz versorgt sind. Die teilweise serielle Schaltung der LED-Chips 8 zu kleinsten funktionsfähigen Untereinheiten 13 ermöglichtes, die Versorgungsspannung des gesamten LED-Leuchtpaneels, oder der Teilstücke 20 desselben, deutlich höher, als dies für einen einzelnen LED-Chip 8 zulässig ist, zu wählen (z.B. 24 V). Wahlweise kann die elektrische Versorgungsspannung als Gleichspannung oder, bei Inkaufnahme eines reduzierten Wirkungsgrades, als Wechselspannung zugeführt werden. Dies ermöglicht erstens die Versorgung des LED-Leuchtpaneels oder der Teilstücke 20 desselben mit gängigen Transformatoren ohne zusätzliche elektronische Bauelemente, und führt zweitens zu einer deutlichen Reduktion der fliessenden Ströme und damit zu einer Minimierung der nötigen Leiterquerschnitte.

Zur Gewährleistung einer Zertrennung des gesamten LED-Leuchtpaneels in beliebige Teilstücke 20, bei welcher die internen elektrischen Leiter 10, 11, 12 einer kleinsten funktionsfähigen Untereinheit 13 nicht beschädigt werden, ist die netzartige Struktur der oberen elektrisch leitenden Schicht 4 jeweils an einer inneren Ecke des einen LED-Chip 8 umschliessenden, von der oberen elektrisch leitenden Schicht 4 geformten Quadrates, mit einer dem LED-Chip 8 zugewandten Anschlussecke 9 versehen. Ebenso liegen die zur Kontaktierung der unteren elektrisch leitenden Schicht 2 notwendigen Öffnungen 5 der Isolationsschicht 3 jeweils innerhalb dieses von der oberen elektrisch leitenden Schicht 4 geformten Quadrates. Der erste elektrische Leiter 10 einer kleinsten funktionsfähigen Untereinheit 13 ist dann von einer Anschlussecke 9 der oberen elektrisch leitenden Schicht 4 hin zu der ebenen Anschlussfläche 6 führbar. Entsprechend ist der letzte elektrische Leiter 12 einer kleinsten funktionsfähigen Untereinheit 13 von der Top-Elektrode des letzten LED-Chips 8 durch die entsprechende Öffnung 5 der Isolationsschicht 3 hin zur unteren elektrisch leitenden Schicht 2 führbar.

Auf diese Weise ist sichergestellt, dass das gesamte LED-Leuchtpaneel entlang den von der oberen elektrisch leitenden Schicht 4 geformten Leiterbahnen ohne Beeinträchtigung der internen elektrischen Leiter 10, 11, 12 zertrennbar ist und damit ohne Verlust von LED-Chips 8 Teilstücke 20a (Fig. 5) mit geradlinigen, senkrecht zueinander angeordneten Randabschnitten herstellbar sind.

Die durch das Legen der Trennflächen entlang den Leiterbahnen der oberen elektrisch leitenden Schicht 4 gegebene Einschränkung der Formgebung des Randes der Teilstücke 20a kann umgangen werden. Unter Inkaufnahme von einigen zerstörten, dann nicht mehr funktionsfähigen kleinsten Untereinheiten 13, kann ein kundenspezifisch oder kundenunabhängig in gleichmässiger Verteilung mit LED-Chips bestücktes gesamtes LED-Leuchtpaneel 1 zu Teilstücken 20b mit beliebig gebogenen oder schiefwinkligen Randformen zertrennt werden, wobei jedes dieser Teilstücke 20b nach Anschluss zweier elektrischer Leiter mit reduzierter Lichtausbeute zu leuchten beginnt. Es besteht aber auch die Möglichkeit, den von den geschilderten Elementen 2, 3, 4, 5, 6 und 7 gebildeten Aufbau mit LED-Chips 8 kundenspezifisch so zu bestücken, dass eine beliebige Kombination unterschiedlicher oder sich wiederholender bestückter Teilstücke 20b mit beliebig gebogenen oder schiefwinkligen Rändern entsteht. Durch Zertrennen des gesamten, derart bestückten LED-Leuchtpaneels entlang diesen Rändern sind funktionsfähige Teilstücke 20b mit eben diesen beliebig gebogenen oder schiefwinkligen Rändern ohne Verlust von LED-Chips herstellbar.

Der Aufbau der von den geschilderten Elementen 2, 3, 4, 5, 6 und 7 gebildeten Struktur ist so gewählt, dass dieser Aufbau mit LED-Chips 8 bestückbar ist, die einen unterschiedlichen elektrischen Spannungsbedarf haben und/oder bei unterschiedlichen Farben leuchten, wobei prinzipiell vielfältige, unterschiedliche LED-Ausführungen enthaltende Mischungen der LED-Chips 8, möglich sind. Sind beispielsweise bei einer Versorgungsspannung des gesamten LED-Leuchtpaneels von 12 Volt, LED-Chips 8 mit Spannungsbedarf 2 Volt und mit Spannungsbedarf 4 Volt gemischt, so sind diejenigen mit Spannungsbedarf 2 Volt in Gruppen von 6 und diejenigen mit Spannungsbedarf 4 Volt in Gruppen von 3 elektrisch seriell schaltbar.

Entsprechend gross ist die Vielfalt der Leuchtfarben der LED-Chips 8 mit welchen der von den geschilderten Elementen 2, 3, 4, 5, 6 und 7 gebildete Aufbau bestückbar ist. Es sind LED-Chips über das gesamte heute verfügbare Farbspektrum, von Blau bis hin zu Infrarot, verwendbar. Auf diese Weise sind LED-Leuchtpaneele herstellbar, die rot oder gelb oder grün oder blau oder mit beliebigen Mischungen dieser Farben leuchten. Insbesondere sind auch weiss leuchtende LED-Leuchtpaneele herstellbar, indem das LED-Leuchtpaneel mit LED-Chips 8 bestückt ist, die ein entsprechendes Mischungsverhältnis der Komplementärfarben aufweisen.

Vorzugsweise ist ein weisses Licht abgebendes LED-Leuchtpaneel aber herstellbar, indem das gesamte LED-Leuchtpaneel mit im kurzwelligen Frequenzbereich (z.B. Blau) leuchtenden LED-Chips 8 bestückt ist und diese im kurzwelligen Frequenzbereich leuchtenden LED-Chips 8 mit Lumineszenzfarbstoff kombiniert sind. Diese Farbstoffe haben die Eigenschaft, durch kurzwelliges Licht bei einer längeren Wellenlänge oder in einem längerwelligen Spektralbereich zum Leuchten angeregt zu werden und sind in sehr feiner Abstufung über das gesamte sichtbare Lichtfrequenzspektrum kommerziell erhältlich. Dadurch ist das Mischungsverhältnis für weisses Licht, das theoretisch einen Grossteil des sichtbaren Spektrums beinhaltet, einstellbar.

Diese Technik zur Erzeugung weiss leuchtender einzeln gehäuster LED ist nicht neu; entsprechende einzeln gehäuste LED sind beispielsweise bei Nichia Chemical Industries kommerziell erhältlich.

Die Breite der möglichen Anwendungen des geschilderten LED-Leuchtpaneels ist durch einen leicht modifizierten Aufbau noch vergrössert. Hierfür ist das LED-Leuchtpaneel mit LED-Chips 8 kundenspezifisch so bestückt, dass eine beliebige Kombination unterschiedlicher oder sich wahlweise in Gruppen wiederholender Teilflächen 21 mit zueinander rechtwinklig angeordneten geraden Rändern 21c oder mit beliebig gebogenen oder schiefwinkligen Rändern 21a, 21b vorhanden ist, wobei diese Teilflächen 21 je mit LED-Chips 8 unterschiedlicher Farbe und/oder mit unterschiedlichem Spannungsbedarf bestückbar sind. Danach ist die obere elektrisch leitende Schicht entlang den Rändern der geschilderten Teilflächen 21 beispielsweise mittels Laserschneidens vollständig elektrisch aufgetrennt, so dass die geschilderten Teilflächen 21 unabhängig voneinander elektrisch kontaktierbar und alle in den jeweiligen Teilflächen 21 vorhandenen LED-Chips 8, je einzeln oder als seriell geschaltete kleinste funktionsfähige Untereinheiten, parallel mit elektrischer Spannung versorgbar sind. Die weiterhin unzertrennt vorhandene, untere elektrisch leitende Schicht dient als, allen geschilderten Teilflächen 21 gemeinsame, zweite elektrische Zuleitung und als eine, das gesamte LED-Leuchtpaneel weiterhin zusammenhaltende Trägerplatte. Nachträglich ist dieses, unabhängig voneinander elektrisch kontaktierbare Teilflächen 21 beinhaltende LED-Leuchtpaneel in Teilstücke 20 zertrennbar, welche jeweils mindestens zwei der geschilderten unabhängig kontaktierbaren Teilflächen 21 umfassen. Auf diese Weise sind gesamte LED-Leuchtpaneele oder Teilstücke 20 derselben herstellbar, bei denen beispielsweise mit LED-Chips unterschiedlicher Farbe bestückte Teilflächen 21 gleichzeitig oder zu verschiednen Zeitpunkten unabhängig voneinander leuchten können.

Zum Schutz gegen chemische und mechanische Einflüsse und gegen eindringende Feuchtigkeit ist die gesamte geschilderte Anordnung beispielsweise durch Giessen mit einer chemisch resistenten, wasserdichten, formfesten und optisch transparenten Schutzschicht 14 (z.B. PMMA) hohlraumfrei überzogen.

In Kombination mit einer wahlweise verstärkten unteren elektrisch leitenden Schicht 2 und einer teilweisen Versenkung der LED-Chips 8 in die hohlspiegelartigen Vertiefungen 7 führt die formfeste optisch transparente Schutzschicht 14 zu einem Aufbau, bei dem auch nach ungewollten (z.B. Steinschlag), oder zur gewollten Beschädigung (Vandalismus) ausgeführten, harten mechanische Schlägen zwar die formfeste optisch transparente Schutzschicht 14 teilweise getrübt wird, die LED-Chips 8 aber weiterhin Licht abgeben. Betrachtet man ein grösseres, zahlreiche kleinste funktionsfähige Untereinheiten 13 umfassendes Teilstück 20 des LED-Leuchtpaneels, so wird durch den geschilderten Aufbau und die parallele Spannungsversorgung der kleinsten funktionsfähigen Untereinheiten 13 sichergestellt, dass das LED-Leuchtpaneel auch nach harter Schlagbelastung weiterhin den Grossteil des von den LED-Chips 8 erzeugten Lichtes abgibt.

Die geschilderte Robustheit gegen ungewollte oder gewollte Beschädigung ist in einer anderen, aufwendigeren Ausführung (Fig. 4) erhöht. Dazu sind die LED-Chips 8 je einzeln mit einem Tropfen aus optisch transparentem, dauerelastischem Material (z.B. Silikon) 17 umhüllt. Das gesamte LED-Leuchtpaneel mit den, mit optisch transparentem, dauerelastischem Material 17 umhüllten LED-Chips 8 , ist wiederum mit der bereits geschilderten formfesten optisch transparenten Schutzschicht 14 überzogen. Der dadurch erhaltene Aufbau bewirkt die annähernd vollständige Ableitung der von mechanischen Schlägen erzeugten Spannungsspitzen über die formfeste optisch transparente Schutzschicht 14 auf die von den Schichten 2, 3 und 4 gebildete stabile Trägerstruktur und schützt so die gegen mechanische Spannungen empfindlichen LED-Chips 8.

Weiter besteht in dieser Ausführung die elektrische Isolationsschicht 3 aus einem sehr zähen Material (z.B. Kapton) und die untere elektrisch leitende Schicht 2 besteht aus einer dicken (z.B. 2 mm) hochfesten Metallplatte (z.B. Stahl). Dadurch wird erreicht, dass bei einem zur Zerstörung durchgeführten Eindringen eines elektrisch leitenden, schlanken Gegenstand (z.B. Nagel) 18 in das LED-Leuchtpaneel oder bei einer Durchdringung des LED-Leuchtpaneels mittels eines elektrisch leitenden schraubenförmigen Gegenstandes, die zähe elektrische Isolationsschicht 3 mindestens ein Stück weit zwischen den zur Zerstörung eingeführten elektrisch leitenden Gegenstand 18 und die untere elektrisch leitende Schicht 2 gezogen wird. Damit wird ein elektrischer Kurzschluss entweder vollständig verhindert oder wenigstens wieder aufgehoben, wenn der in zerstörerischer Absicht eingeführte elektrisch leitende Gegenstand wieder entfernt wird.

Ist die formfeste optisch transparente Schutzschicht 14 , wie in Fig. 1 gezeigt, so strukturiert, dass sie jeweils zwischen den kleinsten funktionsfähigen Untereinheiten 13 deutliche netzartige Abdünnungen 15 aufweist, so ist das gesamte LED-Leuchtpaneel, oder Teilstücke 20 desselben, nach der Fertigstellung in gegebenen Grenzen plastisch deformierbar, so dass beliebige, schalenförmige Leuchtflächen erzeugbar sind. Die vorhandenen netzartigen Abdünnungen 15 der formfesten optisch transparenten Schutzschicht 14 sorgen bei diesem Umformungsvorgang dafür, dass die notwendigen Deformationen nur im Bereich der netzartigen Abdünnungen 15 auftreten und die Bereiche, welche die deformationsempfindlichen LED-Chips 8 tragen, eben bleiben. Zur Unterstützung dieses Effektes der nur lokalen Deformation des LED-Leuchtpaneels oder der Teilstücke 20 desselben bei einem gewollten plastischen Deformationsvorgang, kann die untere elektrisch leitende Schicht 2 auf ihrer unteren Seite ebenfalls mit Abdünnungen versehen sein, welche in Lage und Form den netzartigen Abdünnungen 15 der formfesten optisch transparenten Schutzschicht 14 entsprechen. In einer anderen Ausführungsform kann auf die geschilderten netzartigen Abdünnungen 15 der formfesten optisch transparenten Schutzschicht 14 verzichtet werden.

Hierzu muss der Prozess der gewünschten, nachträglich durchführbaren plastischen Deformation so erfolgen, dass die formfeste optisch transparente Schutzschicht 14 während des Deformationsprozesses als Ganzes oder in Teilbereichen soweit erwärmt wird, dass sie ohne Erzeugung mechanischer Spannungen deformiert werden kann. Bei dieser Ausführungsform ist die formfeste optisch transparente Schutzschicht 14 aus einem Material (z.B. PMMA) aufgebaut, bei dem die Temperatur ab welcher das Material spannungsfrei plastisch deformierbar ist, deutlich unter der für die LED-Chips schädlichen Temperatur liegt.

Die formfeste optisch transparente Schutzschicht 14 ist in Dicke (einige 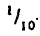 -mm bis einige mm) und Material (z.B. PMMA oder Polycarbonat) so aufgebaut, dass sie nachträglich beispielsweise mittels wahlweise anwendungsspezifischem Prägen durch den Kunden oder den Hersteller mit optisch wirksamen Strukturen 16 (z.B. Prismen und V-Gruben) versehbar ist, welche für sich alleine, oder im Zusammenspiel mit den hohlspiegelartigen Vertiefungen 7 , dazu verwendet werden, eine gewünschte Lichtverteilung zu erzielen, die entweder möglichst gleichförmig ist oder aber auch helle und dunkle Bereiche zur Erzeugung eines gewünschten Bildes aufweist. Durch Kombination der optisch wirksamen Strukturen 16, der hohlspiegelartigen Vertiefungen 7 pro LED-Chip und wahlweise der netzartigen Abdünnungen 15 der formfesten optisch transparenten Schutzschicht 14 ist darüber hinaus eine Beschränkung des Raumwinkels (z.B. 15°) des austretenden Lichtes relativ zur Flächennormalen des LED-Leuchtpaneels erreichbar.

Beispielsweise ist eine möglichst gleichförmige Lichtverteilung dadurch erreichbar, dass die hohlspiegelartige Vertiefung 7 pro LED-Chip 8 vorzugsweise als rotationssymmetrische parabolische Fläche ausgebildet ist, die auf ihrem Grund eine Abflachung aufweist, auf welche der LED-Chip 8 montierbar ist. Auf diese Weise ist der dreidimensionale Lichtfluss der LED-Chips 8 auf einen gewünschten Raumwinkel (z.B. 45 °) relativ zur optischen Achse beschränkbar und damit so lenkbar, dass die Summe der Lichtflüsse der einzelnen LED-Chips 8 die Grenzfläche der formfesten optisch transparenten Schutzschicht 14 in nahezu gleichmässiger Verteilung treffen. Eine gewünschte ungleichmässige Lichtverteilung ist dann mittels optisch wirksamer Strukturen 16 erzeugbar, die beispielsweise nach der Fertigstellung des LED-Leuchtpaneels durch den Hersteller oder durch den Kunden anwendungsspezifisch mittels Prägen der formfesten optisch transparenten Schutzschicht 14 herstellbar sind.

Eine gewünschte Beschränkung des Raumwinkels (z.B. 15°) des austretenden Lichtes relativ zur Flächennormalen des LED-Leuchtpaneels ist dadurch erreichbar, dass die hohlspiegelartigen Vertiefungen 7 pro LED-Chip 8 ebenfalls als rotationssymmetrische parabolische Flächen ausgebildet sind und so zunächst den dreidimensionalen Lichtfluss der LED-Chips 8 auf einen gewünschten Raumwinkel (z.B. 45 °) relativ zur optischen Achse beschränken. Ein Auslegen nachträglich aufgebrachter optisch wirksamerer Strukturen 16 als totalreflektierende Flächen einerseits und als strahlbündelnde Linsen anderseits macht dann den Raumwinkel des austretenden Lichtes relativ zur Flächennormalen des LED-Leuchtpaneels auf den gewünschten Wert beschränkbar. Durch eine entsprechende Auslegung der optisch wirksamen Strukturen 16 ist darüber hinaus erreichbar, dass der Raumwinkel des gesamten, aus einem nachträglich plastisch deformierten, Teilstück 20 des LED-Leuchtpaneels austretende Lichtfluss auf einen bestimmten gewünschten Wert beschränkbar ist.

Die Breite der möglichen Anwendungen des gesamten LED-Leuchtpaneels 1 oder entsprechend konfektionierter Teilstücke 20 der verschiedenen Ausführungen des geschilderten LED-Leuchtpaneels ist gross. Sie reicht vom Fahrzeugbau, bei dem beispielsweise sämtliche am Automobil notwendigen Lichter realisierbar sind, über Lichter zur Lenkung des Verkehrs (z.B. Ampeln) und über Notbeleuchtungen bis hin zu allgemeinen Beleuchtungen in Verkehrssystemen, Industrie, Büro und Wohnbereich.

## Patentansprüche

1. Zerschneidbares LED-Leuchtpaneel (1) beinhaltend einen Aufbau von elektrisch leitenden Strukturen (2, 4), Isolationsstrukturen (3) und elektrischen Anschlussflächen (5, 6) sowie LED (8), welche von diesem Aufbau getragen werden und mittels der elektrischen Anschlussflächen (5, 6) elektrisch parallel kontaktierbar sind, **dadurch gekennzeichnet, dass** das LED-Leuchtpaneel (1) mit LED-Chips (8) aufgebaut ist, dass es eine vorgebbare Verteilung der LED-Chips (8) aufweist und dass es konfektionierbar ist indem es nachträglich in beliebige, je für sich alleine funktionsfähige Teilstücke (20, 21) zertrennbar ist.

2. LED-Leuchtpaneel (1) nach Anspruch 1, **dadurch gekennzeichnet, dass** die LED-Chips (8) gruppenweise elektrisch seriell zu, je parallel mit elektrischer Spannung versorgten, kleinsten funktionsfähigen Untereinheiten (13) schaltbar sind und **dadurch** die Versorgung des gesamten LED-Leuchtpaneels (1), oder eines beliebigen, abgetrennten, mindestens eine dieser kleinsten funktionsfähigen Untereinheiten umfassenden Teilstückes (20, 21) desselben, durch Anschluss an eine Versorgungsspannung möglich ist.

3. LED-Leuchtpaneel (1) nach Anspruch 1, **dadurch gekennzeichnet, dass** es eine Bestückung mit LED-Chips (8) entweder in über die ganze Fläche gleichmässiger Verteilung mit wählbarer Bestückungssdichte, oder in teilstückweise gleichmässiger Verteilung mit unterschiedlicher Bestückungssdichte pro Teilstück (20, 21) aufweist, oder dass die LED-Chips (8) so angeordnet sind, dass Teilstücke (20, 21) mit unterschiedlicher Bestückungssdichte und mit beliebig gebogenen und/oder schiefwinkligen Rändern ohne Verlust an LED-Chips (8) abtrennbar sind.

4. LED-Leuchtpaneel (1) nach Anspruch 1, **dadurch gekennzeichnet, dass** zur Bestückung des gesamten LED-Leuchtpaneels (1) oder mindestens eines Teilstückes (20, 21) desselben, LED-Chips (8), welche unterschiedlichen elektrischen Spannungsbedarf aufweisen und/oder bei unterschiedlichen Farben Licht abgeben, verwendbar sind, wobei das gesamte LED-Leuchtpaneel (1) oder mindestens ein Teilstück (20, 21) desselben, mit LED-Chips (8) ein und derselben spannungsmässigen und/oder farblichen Ausführung der LED-Chips (8) oder mit einer Mischung aus LED-Chips (8) unterschiedlicher spannungsmässiger und/oder farblicher Ausführung bestückt ist.

5. LED-Leuchtpaneel (1) nach Anspruch 1, **dadurch gekennzeichnet, dass** das gesamte LED-Leuchtpaneel (1) oder mindestens ein Teilstück (20, 21) desselben, **dadurch** weiss leuchtet, dass es ein entsprechendes Mischungsverhältnis von in den Komplementärfarben leuchtenden LED-Chips (8) aufweist, oder vorzugsweise im kurzwelligen Spektralbereich leuchtende LED-Chips (8) mit Lumineszenzfarbstoff oder einer Mischung aus Lumineszenzfarbstoffen kombiniert sind.

6. LED-Leuchtpaneel (1) nach Anspruch 2, **dadurch gekennzeichnet, dass** das gesamte LED-Leuchtpaneel (1), wahlweise mit unterschiedlichen LED-Chips (8) bestückt, wahlweise unterschiedlich geformte Teilflächen (21a, b, c) aufweist und mindestens eine der elektrisch leitenden Strukturen (2, 4), welche die parallele Spannungsversorgung der LED-Chips (8) oder der elektrisch seriell geschalteten kleinsten funktionsfähigen Untereinheiten (13) sicherstellen, so strukturiert ist, dass mindestens zwei dieser Teilflächen (21a, b, c) unabhängig voneinander mit elektrischer Spannung versorgt werden können, wobei nach dieser Strukturierung das gesamte LED-Leuchtpaneel (1) als unzertrennte Einheit vorhanden ist und nachträglich in Teilstücke (20, 21) zertrennbar ist, die mindestens zwei der erwähnten, unabhängig mit elektrischer Spannung versorgbaren Teilflächen (21a, b, c) beinhalten.

7. LED-Leuchtpaneel (1) nach Anspruch 2, **dadurch gekennzeichnet, dass** mittels einer formfesten optisch transparenten Schutzschicht (14), wahlweise in Kombination mit einer lokalen Umhüllung pro LED-Chip (8) aus einem optisch transparenten dauerelastischem Material (17), wahlweise in Kombination mit einer mindestens teilweisen Versenkung der LED-Chips (8) in hohlspiegelartige Vertiefungen (7), in Kombination mit der parallelen elektrischen Versorgung aller LED-Chips (8) oder der kleinsten funktionsfähigen Untereinheiten (13), das LED-Leuchtpaneel (1) auch nach ungewollten oder zur gewollten Beschädigung ausgeführten harten mechanischen Schlägen weiterhin Licht abgibt.

8. LED-Leuchtpaneel (1) nach Anspruch 1, **dadurch gekennzeichnet, dass** eine elektrisch isolierende Struktur (3) aus zähem Material, welche zwischen den, der parallelen Spannungsversorgung dienenden elektrisch leitenden Strukturen (2, 4) liegt, einen zur Schädigung des LED-Leuchtpaneels (1) gewaltsam durch diese Strukturen (2, 3, 4) geführten elektrisch leitenden Gegenstand (18) daran hindert einen elektrischen Kurzschluss zu erzeugen oder einen, durch einen solchen gewaltsam eingeführten elektrisch leitenden Gegenstand (18) erzeugten elektrischen Kurzschluss spätestens dann wieder aufhebt, wenn der gewaltsam eingeführte elektrisch leitende Gegenstand (18) wieder entfernt wird

9. LED-Leuchtpaneel (1) nach Anspruch 1, **dadurch gekennzeichnet, dass** mittels einer stellenweisen Abdünnung (15) einer formfesten optisch transparenten Schutzschicht (14) wahlweise kombiniert mit einer in Lage und Form entsprechenden Abdünnung mindestens einer der elektrisch leitenden Strukturen (2, 4), oder mittels der ganzflächigen oder stellenweisen Erwärmung einer formfesten optisch transparenten Schutzschicht (14) wahlweise kombiniert mit einer stellenweisen Abdünnung mindestens einer der elektrisch leitenden Strukturen (2, 4), das LED-Leuchtpaneel (1) oder ein Teilstück (20, 21) desselben, zur Erzielung beliebiger räumlicher Leuchtschalen, plastisch deformierbar ist.

10. LED-Leuchtpaneel (1) nach Anspruch 1, **dadurch gekennzeichnet, dass** eine formfeste optisch transparente Schutzschicht (14) kundenspezifisch mittels optisch wirksamer Strukturen (16) so formbar ist, dass **dadurch** wahlweise im Zusammenspiel mit einem hohlspiegelartigen Element (7) pro LED-Chip (8), eine gewünschte Verteilung des austretenden Lichtes und/oder eine Beschränkung des Raumwinkels des austretenden Lichtes erzielbar ist.

## Claims

1. An LED light panel (1) capable of being cut up, containing a set-up of electrically conductive structures (2, 4), insulation structures (3) and electrical connections surfaces (5, 6), as well as LEDs (8) which are carried by this set-up and may be electrically contacted in parallel by way of the electrical connection surfaces (5, 6), **characterised in that** the LED light panel (1) is constructed with LED chips (8), that it comprises a settable distribution of LED chips (8) and that it is tailorable **in that** at a later stage it may be divided up into arbitrary part pieces (20, 21) which in each case are capable of functioning on their own.

2. An LED light panel (1) according to claim 1, **characterised in that** the LED chips (8) in groups may be connected electrically in series into the smallest, functionable sub-units (13) which in each case are supplied in parallel with electrical voltage, and by way of this the supply of the complete LED light panel (1), or of any, separated part piece (20, 21) of this which comprises at least one of these smallest, functionable sub-units is possible by way of connection to a supply voltage.

3. An LED light panel (1) according to claim 1, **characterised in that** it has an equipping with LED chips (8) either with a distribution which is uniform over the whole surface with a selectable equipping density, or with a uniform distribution in part pieces with a different equipping density per part piece (20, 21), or that the LED chips (8) are arranged such that part pieces (20, 21) with a different equipping density and with arbitrarily bent and/or oblique edges may be separated without the loss of LED chips (8).

4. An LED light panel (1) according to claim 1, **characterised in that** for equipping the complete LED light panel (1) or at least a part piece (20, 21) of this, LED chips (8) which have a different electrical voltage requirement and/or emit light with different colours may be used, wherein the complete LED light panel (1) or at least a part piece (20, 21) of this is equipped with LED chips (8) of one and the same design of the LED chips (8) with regard to voltage and/or colour, or with a mixture of LED chips (8) of different design with regard to voltage and/or colour.

5. An LED light panel (1) according to claim 1, **characterised in that** the complete LED light panel (1) or at least a part piece (20, 21) thereof illuminates in white **in that** it comprises a suitable mixture ratio of LED chips (8) illuminating in the complementary colours, or preferably LED chips (8) illuminating in the short-wave spectral range are combined with luminescence dye or a mixture of luminescence dyes.

6. An LED light panel (1) according to claim 2, **characterised in that** the complete LED light panel (1), equipped selectively with different LED chips (8), selectively comprises differently shaped part surfaces (21a, b, c), and at least one of the electrically conductive structures (2, 4) which ensure the parallel voltage supply of the LED chips (8) or of the smallest, functionable sub-units (13) connected electrically in series, is structured such that at least two of these part surfaces (21a, b, c) may be supplied with electrical voltage independently of one another, wherein after this structuring, the whole LED light panel (1) is present as an undivided unit and at a later stage may be divided up into part pieces (20, 21) which contain at least two of the mentioned part surfaces (21 a, b, c) capable of being supplied independently with electrical voltage.

7. An LED light panel (1) according to claim 2, **characterised in that** the LED light panel (1) also continues to emit light even after hard mechanical impacts which are carried out with unintended damage or for deliberate damage, by way of a dimensionally stable, optically transparent protective layer (14), selectively in combination with a local casing per LED chip (8) of an optically transparent, permanent-elastic material (17), selectively in combination with an at least partial sinking of the LED chips (8) into concave-mirror-like recesses (7), in combination with the parallel electrical supply of all LED chips (8) or of the smallest functionable sub-units (13).

8. An LED light panel (1) according to claim 1, **characterised in that** an electrically insulating structure (3) of tough material which lies between the electrically conductive structures (2, 4) serving the parallel supply of voltage prevents an electrically conductive object (18) led by force through these structures (2, 3, 4) for damaging the LED light panel (1), from producing an electrical short circuit, or lifts an electrical short circuit produced by such an electrically conductive object (18) introduced by force, at the latest when the electrically conductive object (18) introduced by force is removed again.

9. An LED light panel (1) according to claim 1, **characterised in that** the LED light panel (1) or a part piece (20, 21) of this may be plastically deformed for achieving arbitrary spatial light shells, by way a positional thinning (15) of a dimensionally stable, optically transparent protective layer (14) selectively combined with a thinning, which corresponds in position and shape, of at least one of the electrically conductive structures (2,4), or by way of a heating over the whole surface or at locations, of a dimensionally stable, optically transparent protective layer (14) selectively combined with a positional thinning of at least one of the electrically conductive structures (2, 4).

10. An LED light panel (1) according to claim 1, **characterised in that** a dimensionally stable, optically transparent protective layer (14) may be shaped specific to the customer by way of optically effective structures (16) such that by way of this, selectively in cooperation with a concave-mirror-like element (7) per LED chip (8), one may achieve a desired distribution of the exiting light and/or a limitation of the spatial angle of the exiting light.

## Revendications

1. Panneau découpable à diodes électroluminescentes (1) comprenant un assemblage de structures électriquement conductrices (2, 4), de structures d'isolation (3) et de surfaces de raccordement électriques (5, 6) ainsi que des diodes électroluminescentes (8) qui sont supportées par cet assemblage et peuvent être mises en contact électrique parallèle au moyen des surfaces de raccordement électriques (5, 6), **caractérisé en ce que** le panneau à diodes électroluminescentes (1) est assemblé avec des puces à diodes électroluminescentes (8), **en ce qu'**il présente une répartition pouvant être prédéfinie des puces à diodes électroluminescentes (8) et **en ce qu'**il peut être fabriqué par découpage a posteriori en un nombre quelconque de zones (20, 21) fonctionnant chacune individuellement.

2. Panneau à diodes électroluminescentes (1) selon la revendication 1, **caractérisé en ce que** les puces à diodes électroluminescentes (8) peuvent être commutées par groupes en série électrique sur des unités secondaires fonctionnelles minimales (13), alimentées chacune en parallèle en tension électrique, et **en ce que** l'alimentation de l'ensemble du panneau à diodes électroluminescentes (1) ou d'une quelconque zone (20, 21) séparée de celui-ci, comprenant au moins l'une de ces unités secondaires fonctionnelles minimales, est ainsi possible au moyen d'un raccordement à une tension d'alimentation.

3. Panneau à diodes électroluminescentes (1) selon la revendication 1, **caractérisé en ce qu'**il présente une garniture de puces à diodes électroluminescentes (8) soit dans une répartition uniforme sur toute la surface avec une densité de composants ajustable, soit dans une répartition uniforme par zones avec une densité de composants différente pour chaque zone (20, 21), ou **en ce que** les puces à diodes électroluminescentes (8) sont agencées de telle sorte que des zones (20, 21) ayant une densité de composants différente et ayant des bords courbés et/ou à angles obliques quelconques puissent être séparées sans perte de puces à diodes électroluminescentes (8).

4. Panneau à diodes électroluminescentes (1) selon la revendication 1, **caractérisé en ce que**, pour la garniture de l'ensemble du panneau à diodes électroluminescentes (1) ou d'au moins une zone (20, 21) de celui-ci, des puces à diodes électroluminescentes (8) qui présentent différents besoins de tension électrique et/ou émettant une lumière de différentes couleurs peuvent être utilisées, l'ensemble du panneau à diodes électroluminescentes (1) ou au moins une zone (20, 21) de celui-ci étant garni de puces à diodes électroluminescentes (8) d'un seul et même type de puces à diodes électroluminescentes (8) sur le plan de la tension et/ou de la couleur ou d'un mélange de puces à diodes électroluminescentes (8) de différents types sur le plan de la tension et/ou de la couleur.

5. Panneau à diodes électroluminescentes (1) selon la revendication 1, **caractérisé en ce que** l'ensemble du panneau à diodes électroluminescentes (1) ou au moins une zone (20, 21) de celui-ci émet une lumière blanche grâce à un mélange approprié de puces à diodes électro-luminescentes (8) lumineuses dans les couleurs complémentaires ou, de préférence, **en ce que** des puces à diodes électroluminescentes (8) lumineuses dans le domaine spectral des ondes courtes sont combinées avec un colorant luminescent ou un mélange de colorants luminescents.

6. Panneau à diodes électroluminescentes (1) selon la revendication 2, **caractérisé en ce que** l'ensemble du panneau à diodes électroluminescentes (1), garni au choix de différentes puces à diodes électroluminescentes (8), présente des surfaces partielles (21a, b, c) de différentes formes et **en ce qu'**au moins l'une des structures électriquement conductrices (2, 4) qui assurent l'alimentation en tension parallèle des puces à diodes électroluminescentes (8) ou des unités secondaires fonctionnelles les plus petites (13) montées électriquement en série est structurée de telle sorte qu'au moins deux de ces zones (21a, b, c) puissent être alimentées en tension électrique indépendamment l'une de l'autre, où après la définition de cette structure, l'ensemble du panneau à diodes électroluminescentes (1) se présente en tant qu'unité non séparée et peut être divisé a posteriori en zones (20, 21) contenant au moins deux des surfaces partielles (21a, b, c) précitées pouvant être alimentées indépendamment en tension électrique.

7. Panneau à diodes électroluminescentes (1) selon la revendication 2, **caractérisé en ce que** le panneau à diodes électroluminescentes (1) continue d'émettre une lumière même après des impacts mécaniques substantiels involontaires ou portés aux fins d'un endommagement volontaire, grâce à une couche de protection rigide (14) optiquement transparente, éventuellement en combinaison avec une enveloppe locale autour de chaque puce à diodes électroluminescentes (8) réalisée dans un matériau optiquement transparent durablement élastique, éventuellement en combinaison avec un encastrement au moins partiel des puces à diodes électroluminescentes (8) dans des enfoncements en forme de miroirs concaves (7), en combinaison avec l'alimentation électrique parallèle de toutes les puces à diodes électroluminescentes (8) ou des unités secondaires fonctionnelles minimales (13).

8. Panneau à diodes électroluminescentes (1) selon la revendication 1, **caractérisé en ce qu'**une structure électriquement isolante (3) en un matériau ductile, qui se trouve entre les structures électriquement conductrices (2, 4) servant à l'alimentation en tension parallèle, empêche qu'un objet électriquement conducteur (18) introduit de force à travers ces structures (2, 3, 4) aux fins de l'endommagement du panneau à diodes électroluminescentes (1) ne provoque un court-circuit électrique ou élimine un court-circuit électrique provoqué par un tel objet électriquement conducteur (18) introduit de force, au plus tard lorsque l'objet électriquement conducteur (18) introduit de force est à nouveau retiré.

9. Panneau à diodes électroluminescentes (1) selon la revendication 1, **caractérisé en ce que** le panneau à diodes électroluminescentes (1) ou une zone (20, 21) de celui-ci peut être déformé de façon plastique aux fins de la production de coupes lumineuses quelconques, grâce à un amincissement localisé (15) d'une couche de protection (14) rigide, optiquement transparente, éventuellement en combinaison avec un amincissement correspondant, dans l'emplacement et la forme, d'au moins l'une des structures électriquement conductrices (2, 4), ou grâce au chauffage, sur toute la surface ou localisé, d'une couche de protection (14) rigide optiquement transparente, éventuellement en combinaison avec un amincissement localisé d'au moins l'une des structures électriquement conductrices (2, 4).

10. Panneau à diodes électroluminescentes (1) selon la revendication 1, **caractérisé en ce qu'**une couche de protection (14) rigide, visuellement transparente peut être formée de façon spécifique à un client grâce à des structures visuellement actives (16) de telle sorte qu'une répartition souhaitée de la lumière émise et/ ou une limitation de l'angle solide de la lumière émise peut ainsi être obtenue, au choix, en conjonction avec un élément en forme de miroir concave (7) pour chaque puce à diodes électroluminescentes (8).
